# EUROPEAN PATENT APPLICATION

(11) **EP 4 287 266 A1**
(43) Date of publication of application: **06.12.2023**
(21) Application number: 22745240.6
(22) Date of filing: 25.01.2022
(51) Int. Cl.: H01L 29/82, H01L 29/66, H01L 29/10, H01L 29/45

(54) **SEMICONDUCTOR QUANTUM DOT DEVICE AND PREPARATION METHOD THEREFOR, AND SIGNAL READING METHOD AND MANIPULATION METHOD**

(30) Priority: 29.01.2021 CN 202110130676; 29.01.2021 CN 202120274509 U; 26.02.2021 CN 202120434495 U
(71) Applicant: Origin Quantum Computing Technology (Hefei) Co., Ltd, Hefei, Anhui 230088 (CN)
(72) Inventor: KONG, Weicheng, Hefei, Anhui 230088 (CN); ZHANG, Hui, Hefei, Anhui 230088 (CN); ZHAO, Yongjie, Hefei, Anhui 230088 (CN)
(74) Representative: Rau, Schneck & Hübner Patentanwälte Rechtsanwälte PartGmbB
(86) International application number: PCT/CN2022/073861
(87) International publication number: WO 2022/161366

(57) **Abstract**

The present application discloses a semiconductor quantum dot device structure, fabrication method, signal reading method and manipulation method. The structure includes: a silicon substrate formed to be provided with a first ion region and a second ion region; a dielectric layer located on the silicon substrate layer, with a carrier channel formed at an interface between the silicon substrate and the dielectric layer; the first electrode in ohmic contact with the first ion region, and the second electrode in ohmic contact with the second ion region; A confining electrode located on the dielectric layer, configured to confine carriers within the carrier channel to form quantum dots; and a magnetic electrode, the magnetic electrode is configured to form a magnetic field gradient at the interface and to The quantum dots are manipulated. The application also discloses a semiconductor quantum dot device.

## Description

This disclosure claims priority to: Chinese Patent Application No. 202110130676.2 entitled "SEMICONDUCTOR QUANTUM DOT DEVICE AND FABRICATION METHOD, SIGNAL READING METHOD AND MANIPULATION METHOD THEREFOR" filed with the CNIPA on January 29, 2021; Chinese Patent Application No. 202120274509.0 entitled "SEMICONDUCTOR QUANTUM DOT DEVICE AND COMPUTER" filed with the CNIPA on January 29, 2021; and Chinese Patent Application No. 202120434495.4 entitled "SEMICONDUCTOR QUANTUM DOT DEVICE" filed with the CNIPA on February 26, 2021; all of which are hereby incorporated by reference in their entireties.

### TECHNICAL FIELD

The application relates to the field of quantum technologies, and in particular relates to a semiconductor quantum dot device and a fabrication method, a signal reading method, and a manipulation method therefor.

### BACKGROUND

With rapid development of modern technologies for manufacturing large-scale integrated circuits, sizes of integrated components in a chip are increasingly reducing, as a result, the Quantum Effect is becoming more and more non-negligible. Among various solutions to the crisis of failure of Moore's Law, the quantum computer designed based on the principle of quantum mechanics has become the world's important layout and strategic highland in the field of science and technology, due to its breakthrough on performance improvement and excellent application of quantum algorithms (such as distribution and cracking of the current classical computer keys, etc.).

Among various qubit schemes of quantum computers, quantum dot systems based on semiconductor material systems, such as those fabricated with materials such as GaAs/AlGaAs, SiO₂/Si, Si/SiGe, etc, are considered to be the most promising bit-encoding supporters for realization of quantum computing. Semiconductor quantum dots are excellent in quantum coherence, and integration thereof is facilitated with existing micro-nano processing technologies for large-scale integrated circuits. In addition, semiconductor quantum dot structures are less susceptible to external environmental interference, making it easier to achieve stable manipulation of qubits. Therefore, compared with other quantum computing systems, semiconductor quantum dots have greater prospects and advantages.

Manipulation methods and performance is one of the important directions of quantum computing research. For single-spin qubits, manipulation methods therefor include electro spin resonance using antennas, as well as electric dipole spin resonance using spin-orbit coupling or external micromagnets. For silicon-related semiconductor quantum dot devices, their weak hyperfine interaction and spin-orbit coupling can keep electron spins for a longer decoherence time. However, existing electrical manipulation methods for silicon-related semiconductor quantum dot devices are quite limited.

In order to achieve excellent electrical manipulation performance, it is of the most importance to obtain semiconductor quantum dot devices with high-quality materials and structures, which decisively influences bit properties of semiconductor quantum dot devices, and further influences quality of qubit manipulation.

Fabrication processes of semiconductor quantum dot structures are similar to fabrication processes of traditional integrated circuit chips. Currently, a widely used method is to fabricate, on substrate materials including a silicon substrate and a silicon dioxide layer, a plurality of quantum dot electrodes for forming and controlling quantum dots; wherein the quantum dot electrodes are all fabricated on a two-dimensional plane of the silicon dioxide layer. Where there are an increased number of quantum dots and accuracy of manipulation thereof becomes more demanding, quantum dot electrodes fabricated in a two-dimensional plane are difficult to integrate, and are poor in manipulation of quantum dots, making it difficult to provide guarantees for parameters of semiconductor quantum chips.

### SUMMARY

The present application aims at providing a semiconductor quantum dot device, and a fabrication method, a manipulation method, and a reading method therefor, in order to solve deficiencies in the prior art: through the mixing effect between electro spin and valley energy levels, it can construct qubits, and has a strong capability in electric field manipulation. The present application also aims at providing a semiconductor quantum dot device in order to solve the deficiencies in the prior art: by arranging the quantum dot electrodes in a stacked way, it can facilitate adjustment of sizes and relative positions of the electrodes and improve adjustability of quantum dot parameters.

The present application adopts the following technical solutions:
A semiconductor quantum dot device, including: a silicon substrate; and a dielectric layer located on the silicon substrate.

Further, the semiconductor quantum dot device includes: a silicon substrate formed to be provided with a first ion region and a second ion region; a dielectric layer located on the silicon substrate, with a carrier channel formed at an interface between the silicon substrate and the dielectric layer; a first electrode in ohmic contact with the first ion region, and a second electrode in ohmic contact with the second ion region; a confining electrode located on the dielectric layer, configured to confine carriers within the carrier channel to form quantum dots; and a magnetic electrode configured to form a magnetic field gradient at the interface and configured to manipulate the quantum dots.

Further, the dielectric layer is one of a silicon dioxide layer, a silicon-germanium heterojunction layer, and a nanowire material layer.

Further, the confining electrode includes a plurality of gate electrodes arranged in an overlapping way, and insulating layers are formed between adjacent gate electrodes.

Further, the confining electrode includes: a first guiding electrode and a second guiding electrode, located between the first electrode and the second electrode; a first pumping electrode located between the first guiding electrode and the second guiding electrode and arranged alternately with the first guiding electrode and the second guiding electrode; and a second pumping electrode and a third pumping electrode, wherein the second pumping electrode is located between the first guiding electrode and the first pumping electrode, and the third pumping electrode is located between the second guiding electrode and the first pumping electrode.

Further, the dielectric layer partially covers the first ion region and the second ion region, and wherein the first guiding electrode extends to cover part of the first ion region, and the second guiding electrode extends to cover part of the second ion region.

Further, the magnetic electrode is an iron electrode or a cobalt electrode.

Further, the semiconductor quantum dot device also includes a first channel electrode and a second channel electrode both located on the dielectric layer, wherein a one-dimensional channel is formed between the first channel electrode and the second channel electrode, and wherein the confining electrode, the first electrode and the second electrode are all located in the one-dimensional channel.

Further, the semiconductor quantum dot device includes:
a silicon substrate;
a silicon dioxide layer located on the silicon substrate, with an ion implantation window formed on the silicon dioxide layer, wherein the ion implantation window is configured to implant ions into the silicon substrate;
a first insulating layer located on the silicon dioxide layer, with ohmic electrodes formed on the first insulating layer, the ohmic electrodes being in ohmic contact with implanted ions;
a quantum dot window located on the silicon dioxide layer, the quantum dot window being located between the ohmic electrodes and exposing the silicon dioxide layer; and
a first metal electrode and a magnet located in the quantum dot window, wherein the first metal electrode is arranged in a stacked way, the first metal electrode is configured to form quantum dots, and the magnet is configured to control the quantum dots.

In the above-mentioned semiconductor quantum dot device, preferably, a second metal electrode is also formed on the first insulating layer, and the second metal electrode is electrically connected to the first metal electrode in one-to-one correspondence, wherein, the second metal electrode is located outside the quantum dot window, and is configured to transmit a received voltage control signal to the first metal electrode.

In the above-mentioned semiconductor quantum dot device, preferably, the first metal electrode includes:
first metal sub-electrodes, arranged in parallel in the quantum dot window, and are configured to form channels;
second metal sub-electrodes, located on the first metal sub-electrodes, and are configured to form quantum dots in the channels;
third metal sub-electrodes, located on the second metal sub-electrodes, and are configured to adjust coupling parameters of the quantum dots;
wherein, second insulating layers are formed between the first metal sub-electrode and the second metal sub-electrode, and between the second metal sub-electrode and the third metal sub-electrode.

In the above-mentioned semiconductor quantum dot device, preferably, the second metal sub-electrodes and the third metal sub-electrodes are arranged alternately in a horizontal direction.

In the above-mentioned semiconductor quantum dot device, preferably, the first metal sub-electrodes, the second metal sub-electrodes and the third metal sub-electrodes are all made of aluminum, and the second insulating layers are made of alumina oxide.

In the above-mentioned semiconductor quantum dot device, preferably, the magnet is located above the third metal sub-electrodes.

In the above-mentioned semiconductor quantum dot device, preferably, the magnet includes a first metal layer and a second metal layer, wherein the second metal layer is located on the first metal layer.

In the above-mentioned semiconductor quantum dot device, preferably, the first metal layer is made of titanium, and the second metal layer is made of cobalt.

In the above-mentioned semiconductor quantum dot device, preferably, a thickness of the first metal layer is 10 nm, and a thickness of the second metal layer is 250 nm.

In the above-mentioned semiconductor quantum dot device, preferably, the magnet is of one of the following shapes: a trapezoid, a U-shape, and a ring-shape.

The present application also proposes a fabrication method for a semiconductor quantum dot device, including: forming a first ion region and a second ion region on a silicon substrate; forming a dielectric layer located on the silicon substrate, with a carrier channel formed at an interface between the silicon substrate and the dielectric layer; forming a first electrode in ohmic contact with the first ion region, and a second electrode in ohmic contact with the second ion region; forming a confining electrode located on the dielectric layer, the confining electrode being configured to confine carriers within the carrier channel to form quantum dots; forming a magnetic electrode, the magnetic electrode being configured to form a magnetic field gradient at the interface and to receive microwave signals for manipulating the quantum dots.

Further, the method also includes: forming a first channel electrode and a second channel electrode both located on the dielectric layer, wherein a one-dimensional channel is formed between the first channel electrode and the second channel electrode, and wherein the confining electrode, the first electrode and the second electrode are all located in the one-dimensional channel.

The present application also provides a signal reading method for a semiconductor quantum dot device, the signal reading method including: providing a magnetic field and applying it to the semiconductor quantum dot device; providing a voltage and applying it to the first electrode, the second electrode and the confining electrode; providing a microwave signal and applying it to the magnetic electrode; and acquiring an electrical signal output by the second electrode.

The present application also provides a manipulation method for a semiconductor quantum dot device, the manipulation method including: forming a magnetic field gradient via the magnetic electrode, to split a valley energy level of the quantum dots and obtain split energy levels; and applying microwave signals via the magnetic electrode to adjust energy level transitions between the split energy levels, so as to implement manipulation of states of the quantum dots.

Further, the split energy levels include: a first valley spin energy level, a second valley spin energy level, a third valley spin energy level and a fourth valley spin energy level, wherein the second valley spin energy level and the third valley spin energy level are anti-crossing; and a frequency of the microwave signals corresponds to transition energy between the second valley spin level and the third valley spin level.

The present application also provides a quantum computer, including the semiconductor quantum dot device described in any one of the above features, or the semiconductor quantum dot device fabricated according to the method described in any one of the above features, or the semiconductor quantum dot device manipulated according to the method described in any one of the above features.

Compared with the prior art, the semiconductor quantum dot device provided by the first aspect of the present application forms, via the magnetic electrode, a magnetic field gradient at the interface, and the magnetic electrode can vary the magnetic field gradient at the interface between the silicon substrate and the dielectric layer according to the magnetic field intensity vector applied to the semiconductor quantum dot device, thereby splitting the valley energy level of the carriers at the quantum dots, and thus obtaining split energy levels suitable for electrical manipulation via microwave signals applied to the magnetic electrode. Compared with structures such as antennas, the magnetic electrode used in the present application is relatively small, having structural advantages facilitating its integration.

Compared with the prior art, the fabrication method for a semiconductor quantum dot device provided in the second aspect of the present application can fabricate the semiconductor quantum dot device provided in the first aspect of the present application.

Compared with the prior art, the manipulation method for semiconductor quantum dot devices provided in the third aspect of the present application forms, via a magnetic electrode, a magnetic field gradient so as to split a valley energy level of the quantum dots and obtain split energy levels, and applies microwave signals via the magnetic electrode to adjust energy level transitions between the split energy levels, so as to implement manipulation of states of the quantum dots. Compared with traditional control between spin energy levels, states of quantum dots in the present application are adjusted between the split energy levels, and has the advantage of fast manipulation speed. As a result, the present application is relatively strong in the manipulation capability of electric fields.

Compared with the prior art, the semiconductor quantum dot device of the present application may include: a silicon substrate; a silicon dioxide layer located on the silicon substrate, with an ion implantation window formed on the silicon dioxide layer, wherein the ion implantation window is configured to implant ions into the silicon substrate; a first insulating layer located on the silicon dioxide layer, with ohmic electrodes formed on the first insulating layer, the ohmic electrodes being in ohmic contact with implanted ions; a quantum dot window located on the silicon dioxide layer, the quantum dot window being located between the ohmic electrodes and exposing the silicon dioxide layer; and a first metal electrode and a magnet located in the quantum dot window, wherein the first metal electrode is arranged in a stacked way, the first metal electrode is configured to form quantum dots, and the magnet is configured to control the quantum dots. By forming the first metal electrodes arranged in a stacked way in the quantum dot window, size and relative position of the first metal electrodes can be adjusted, thereby improving adjustability of parameters of the quantum dots.

### BRIEF DESCRIPTION OF THE DRAWINGS

FIG. 1 is a schematic structural illustration of a semiconductor quantum dot device provided in an embodiment of the present application, wherein FIG. 1 (2) is a schematic cross-sectional view of FIG. 1 (1);
FIG. 2 is a flow chart of a fabrication method for a semiconductor quantum dot device provided in an embodiment of the present application;
FIG. 3 is a schematic structural illustration corresponding to each process step in the flowchart of Fig. 2;
FIG. 4 is a flow chart of a signal reading method for a semiconductor quantum dot device provided in an embodiment of the present application;
FIG. 5 is a schematic structural illustration of a signal reading system for a semiconductor quantum dot device provided in an embodiment of the present application;
FIG. 6 is a flowchart of a manipulation method for a semiconductor quantum dot device provided in an embodiment of the present application;
FIG. 7 is a schematic illustration of energy level splitting of a semiconductor quantum dot device provided in an embodiment of the present application under the action of a magnetic field;
FIG. 8 and FIG. 9 are illustrations showing the electrical manipulation effects of a semiconductor quantum dot device provided in an embodiment of the present application.
FIG. 10 is a schematic cross-sectional view of an overall structure of a semiconductor quantum dot device provided in an embodiment of the present application;
FIG. 11 is a schematic illustration of a second metal electrode of a semiconductor quantum dot device provided in an embodiment of the present application;
Fig. 12a is a schematic illustration of a stacked structure of a first metal electrode provided in an embodiment of the present application;
FIG. 12b is a cross-sectional view of the quantum dot window provided in an embodiment of the present application;
Fig. 13 is a schematic illustration of a shape of a magnet provided in an embodiment of the present application.

Reference Signs: 101- silicon substrate, 102- dielectric layer, 103 -first ion region, 104- second ion region, 201- first electrode, 202- second electrode, 203- first guiding electrode, 204- second guiding electrode, 205- first pumping electrode, 206- second pumping electrode, 207- third pumping electrode, 208- first channel electrode, 209- second channel electrode, 210- second quantum dot, 211- first quantum dot, 212- third quantum dot, 213- magnetic electrode, 301- semiconductor quantum dot device, 302- DC bias voltage source, 303- microwave source, 304- signal amplifier, 305- voltage testing device, 1001-silicon substrate, 1002- silicon dioxide layer, 1003- two-dimensional carrier channel, 2000-ion implantation window (2001, 2002, 2003, 2004), 3000- ohm electrode (3001, 3002, 3003, 3004), 4000-first insulating layer, 5000- quantum dot window, 6001, 6002, 6003- first metal electrode, 3011, 3012, 3013, 6011, 6012, 6013, 6014- second metal electrode, 7000- magnet, 7001- first metal layer, 7002- second metal layer, 8000- quantum dot (8001,8002,8003), 6001- first metal sub-electrode, 6002- second metal sub-electrode, 6003- third metal sub-electrode, 9000- second insulating layer.

### DETAILED DESCRIPTION

The embodiments described below with reference to the figures are exemplary and only for explaining the present application, and are not to be construed as limitation thereto.

### Embodiment 1

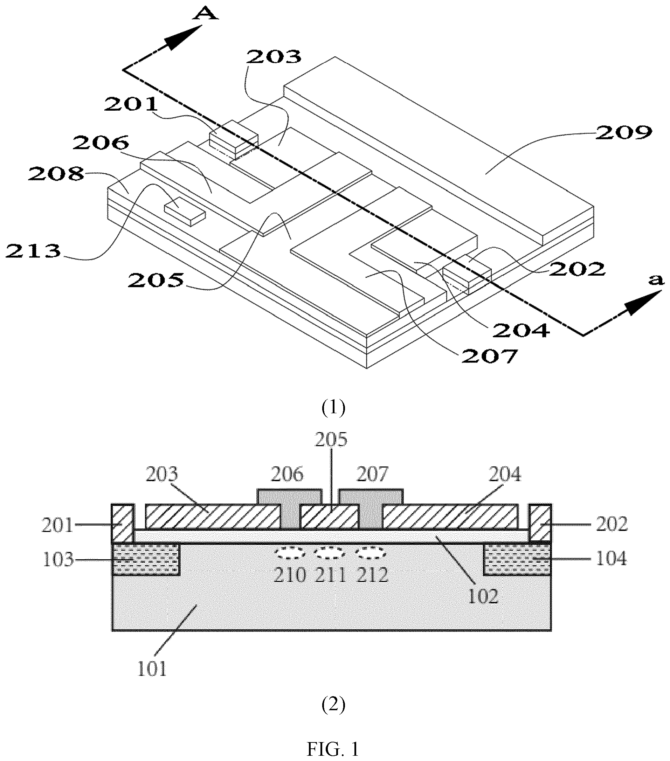

FIG. 1 is a schematic structural illustration of a semiconductor quantum dot device provided in an embodiment of the present application, wherein FIG. 1 (2) is a schematic cross-sectional view of FIG. 1 (1);

As shown in FIG. 1, this embodiment provides a semiconductor quantum dot device structure, including: a silicon substrate 101 formed to be provided with a first ion region 103 and a second ion region 104; a dielectric layer 102 located on the silicon substrate 101, with a carrier channel formed at an interface between the silicon substrate 101 and the dielectric layer 102; a first electrode 201 in ohmic contact with the first ion region 103, and a second electrode 202 in ohmic contact with the second ion region 104; a confining electrode located on the dielectric layer 102, configured to confine carriers within the carrier channel to form quantum dots; and a magnetic electrode 213, configured to form a magnetic field gradient at the interface and configured to manipulate the quantum dots.

In the field of semiconductor quantum dot fabrication, a stack of silicon substrate 101 and dielectric layer 102 is used to fabricate quantum dots at the interface in the middle of the stack. Specifically, the first ion region 103 and the second ion region 104 are fabricated on opposite sides of the silicon substrate 101 for storing and outputting electrons. Respectively, a first electrode 201 (i.e. the source) connected to the first ion region 103 is fabricated right above the first ion region 103, a second electrode 202 (i.e. the drain) connected to second ion region 104 is fabricated right above the second ion region 104. The first electrode 201 and the second electrode 202 function as the source and drain in a semiconductor chip. Direction of electron transmission can be constrained by applying a first DC bias voltage to form a current required for directional transmission of electrons (i.e., to form a carrier channel current), wherein the first DC bias voltage may include a positive voltage, a negative voltage, and the like. Further, a confining electrode is fabricated on the dielectric layer 102 to confine the number of electrons within the carrier channel. By applying a preset DC bias voltage, only a limited number of electrons (that is, quantum dots) are remained right under the confining electrode; in addition, based on spin characteristics of electrons (spin up and spin down), a two-energy-level system is designed to form a qubit.

In addition, by providing the magnetic electrode 213 which is configured to manipulate the quantum dots, specifically, the valley energy level of the electrons is split by the magnetic field signal applied on the magnetic electrode 213, forming a two-energy-level system with a spin-up (high energy level) and a spin-down (low energy level), where the system energy level difference depends on the magnitude of the applied magnetic field signal. Then, a microwave signal is applied via the magnetic electrode 213. When the frequency of the applied microwave signal resonates with the energy level difference of the two-energy-level system, electrons in the energy level system will absorb or emit photons due to resonance, and thus energy level transitions will occur. For example, an electron that spins upwards will transition to a lower energy level corresponding to an electron that spins downwards (spin down), i.e., the spin direction of the electron changes from "spin-up" to "spin-down". Similarly, an electron that spins downwards absorbs photons and transitions to a higher energy level (spin up) under the action of resonance of microwave signals. By applying a microwave signal through the magnetic electrode 213 to realize electrical manipulation of quantum dots, and disposing the magnetic electrode 213 in the semiconductor quantum dot device, integration degree of the semiconductor quantum dot device may be effectively improved.

The dielectric layer 102 is one of a silicon dioxide layer, a silicon-germanium heterojunction layer, and a nanowire material layer.

In the manufacturing process of semiconductor quantum dot devices, the dielectric layer 102 configured to fabricate the electrodes that bind the quantum dots can generally be made of: gallium arsenide\aluminum gallium arsenide heterojunction, silicon\silicon-germanium heterojunction, germanium\silicon-germanium heterojunction, solid materials such as silicon metal oxide semiconductors, two-dimensional materials such as graphene and molybdenum disulfide, one-dimensional materials such as indium arsenic nanowires, silicon-germanium nanowires, silicon nanowires, and carbon nanotubes, zero-dimensional materials such as germanium crystals, etc.

The confining electrode includes a plurality of gate electrodes arranged in an overlapping way, and insulating layers are formed between adjacent gate electrodes.

The confining electrode is an electrode arranged on the dielectric layer 102 to restrain the number of electrons in the carrier channel, and its function is the same as that of the gate in a semiconductor device. By applying a preset DC bias voltage, only a limited number of electrons (that is, quantum dots) are remained right below the confining electrode. In order to realize multiple quantum dot structures, gate electrodes are provided in an overlapping way, so that quantum dots are formed under each gate electrode. In addition, insulating layers are provided between the plurality of gate electrodes, which can effectively isolate the gate electrodes from each other to avoid short circuit, leakage, and the like.

The confining electrode includes: a first guiding electrode 203 and a second guiding electrode 204 both located between the first electrode 201 and the second electrode 202; a first pumping electrode 205 located between the first guiding electrode 203 and the second guiding electrode 204 and arranged alternately with the first guiding electrode 203 and the second guiding electrode 204; and a second pumping electrode 206 and a third pumping electrode 207, wherein the second pumping electrode 206 is located between the first guiding electrode 203 and the first pumping electrode 205, and the third pumping electrode 207 is located between the second guiding electrode 204 and the first pumping electrode 205.

As shown in FIG. 1, the confining electrode includes a first guiding electrode 203 and a second guiding electrode 204, wherein the first guiding electrode 203 and the second guiding electrode 204 are both arranged between the first electrode 201 and the second guiding electrode 201. When performing electrical manipulation on a quantum dot device, a carrier channel can be formed by applying a second DC bias voltage on the first guiding electrode 203 and the second guiding electrode 204, and then applying a first DC bias voltage on the first electrode 201, to form a current in the carrier channel.

Having formed a current in the carrier channel, it is still necessary to apply a pumping voltage signal to evacuate most of the electrons in the current, leaving only a few electrons. Here, the number of pumping voltages applied is equal to the number of quantum dots formed. For example, during utilization of the present application, the first pumping electrode 205, the second pumping electrode 206, and the third pumping electrode 207 are arranged, so that corresponding positions below these pumping electrodes retain only a few electrons and form three quantum dots. The first pumping electrodes 205 , the second pumping electrodes 206 and the third pumping electrodes 207 are alternately arranged between the first guiding electrodes and the second guiding electrodes.

In addition, different pumping voltage signals are applied on the first pumping electrode 205, the second pumping electrode 206 and the third pumping electrode 207. In particular, the first pumping electrode 205 needs to be applied a second bias voltage of the same order of magnitude as the first guiding electrode or the second guiding electrode, e.g. a positive voltage; while the second pumping electrode 206 and the third pumping electrode 207 need to be applied smaller positive voltages than that on the first pumping electrode 205.

The dielectric layer 102 partially covers the first ion region 103 and the second ion region 104, and the first guiding electrode 203 extends to cover part of the first ion region 103, and the second guiding electrode 204 extends to cover part of the second ion region 104 .

As shown in FIG. 1 , the first ion region 103 and the second ion region 104 are configured to store and generate electrons, wherein quantity and movement direction of these electrons need to be controlled via the first electrode 201 and the second electrode 202, that is, the first electrode 201 is in ohmic contact with the first ion region 103, and the second electrode 202 is in ohmic contact with the second iron region 104. On the other hand, the dielectric layer 102 and the silicon substrate 101 are stacked in layers. When fabricating the first electrode 201 and the second electrode 202 on the dielectric layer 102, it is necessary to remove by an etching process, from the dielectric layer 102, the contact region between the first electrode 201 and the first ion region 103 and the contact region between the second electrode 202 and the second ion region 104, thereby ensuring stability of ohmic contact, that is, the dielectric layer 102 partially covers the first ion region 103 and the second ion region 104. Moreover, the first guiding electrode 203 and the second guiding electrode 204 in the confining electrode are configured to apply a second bias voltage to form a carrier channel, and therefore, the first guiding electrode 203 extends to cover part of the first ion region 103, and the second guiding electrode 204 extends to cover part of the second ion region 104.

The magnetic electrode 213 an iron electrode or a cobalt electrode. The material of the magnetic electrode 213 may be selected from magnetic materials such as iron, cobalt, and nickel. During fabrication, semiconductor quantum dot devices may be formed by electron beam lithography and electron beam evaporation coating, such as using electron beam evaporation coating on the surface of the dielectric layer 102 so as to coat the magnetic material to form the magnetic electrode 213. In the present application, the position of the magnetic electrode 213 is not limited thereto, as long as it can form a magnetic field gradient at the interface and receive microwave signals for manipulating the quantum dots.

The semiconductor quantum dot device further includes a first channel electrode 208 and a second channel electrode 209 both located on the dielectric layer 102, wherein a one-dimensional channel is formed between the first channel electrode 208 and the second channel electrode 209, and wherein the confining electrode, the first electrode 201 and the second electrode 202 are all located in the one-dimensional channel.

As shown in FIG. 1, a one-dimensional channel is also provided on the dielectric layer 102. As is well known in the semiconductor field, a "channel" refers to a semiconductor layer between the source and the drain in the transistor: in the present application, it is arranged along the horizontal direction of the first electrode 201 and the second electrode 202. Specifically, by providing the first channel electrode 208 and the second channel electrode 209 on the dielectric layer 102, a one-dimensional channel is formed between the first channel electrode 208 and the second channel electrode 209.

The one-dimensional channel corresponds to the carrier channel. The one-dimensional channel is arranged along the horizontal direction of the first electrode 201 and the second electrode 202. When the first DC bias voltage is applied to the first electrode 201 and the second electrode 202, and forms a current in the carrier channel, the carrier channel is in a one-dimensional channel region; that is, the electrons move in the one-dimensional channel. Therefore, the confining electrode that controls the electrons in the carrier channel also needs to be provided in a one-dimensional channel.

As provided by the first aspect of the present application, the semiconductor quantum dot device forms, via the magnetic electrode 213, a magnetic field gradient at the interface. Further, the magnetic electrode 213 can vary the magnetic field gradient at the interface between the silicon substrate 101 and the dielectric layer 102 according to the magnetic field intensity vector applied to the semiconductor quantum dot device, thereby splitting the valley energy level of the carriers at the quantum dots, and thus obtaining split energy levels suitable for electrical manipulation via microwave signals applied to the magnetic electrode 213. Compared with structures such as antennas, the magnetic electrode 213 used in the present application is relatively small, having structural advantages facilitating its integration.

### Embodiment 2

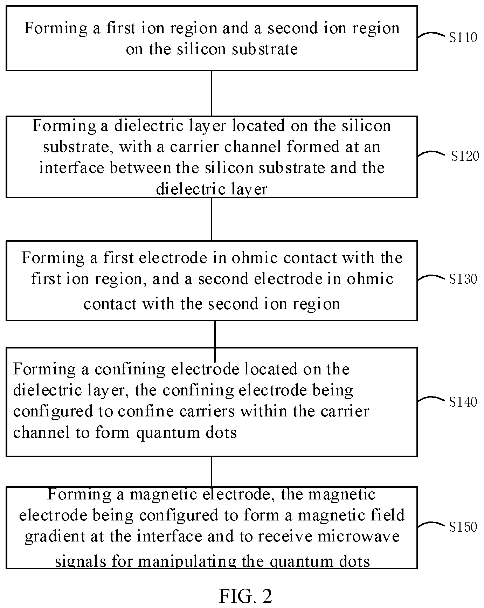

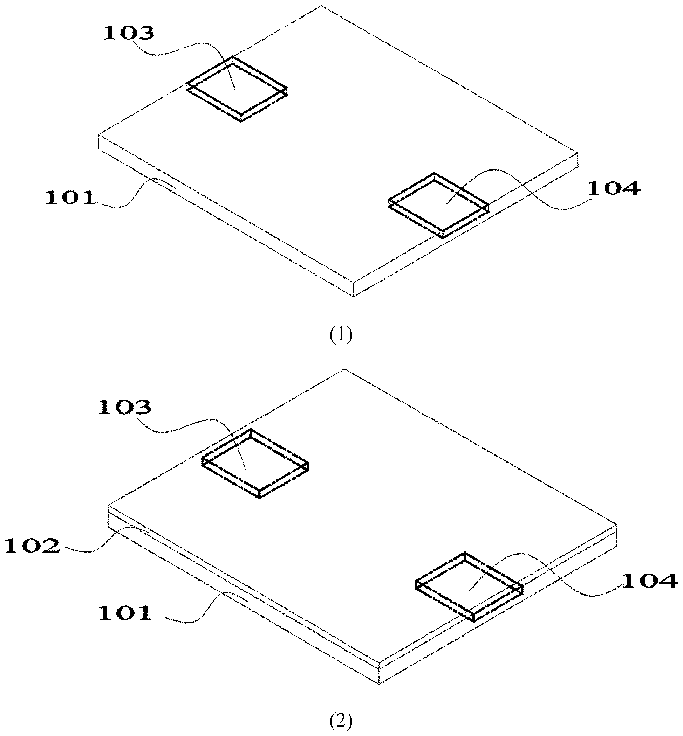

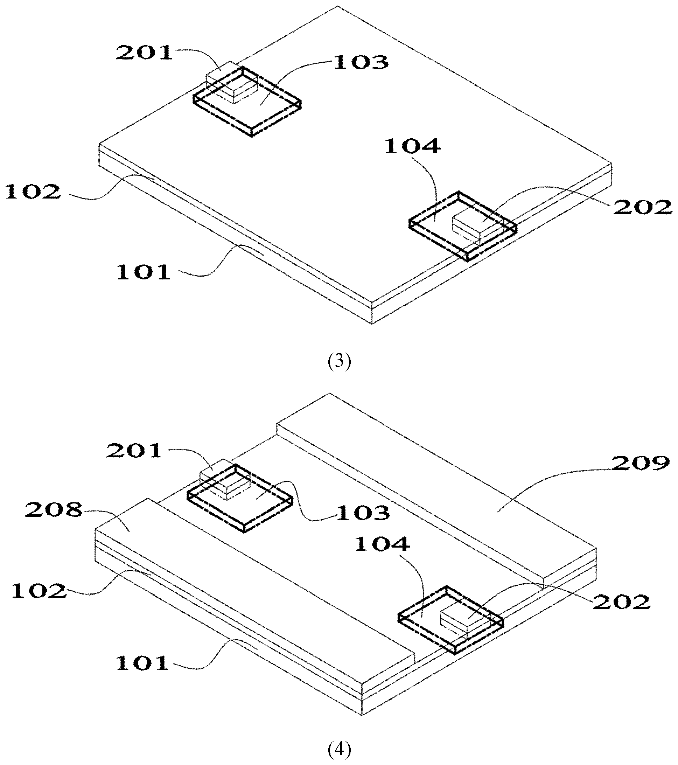

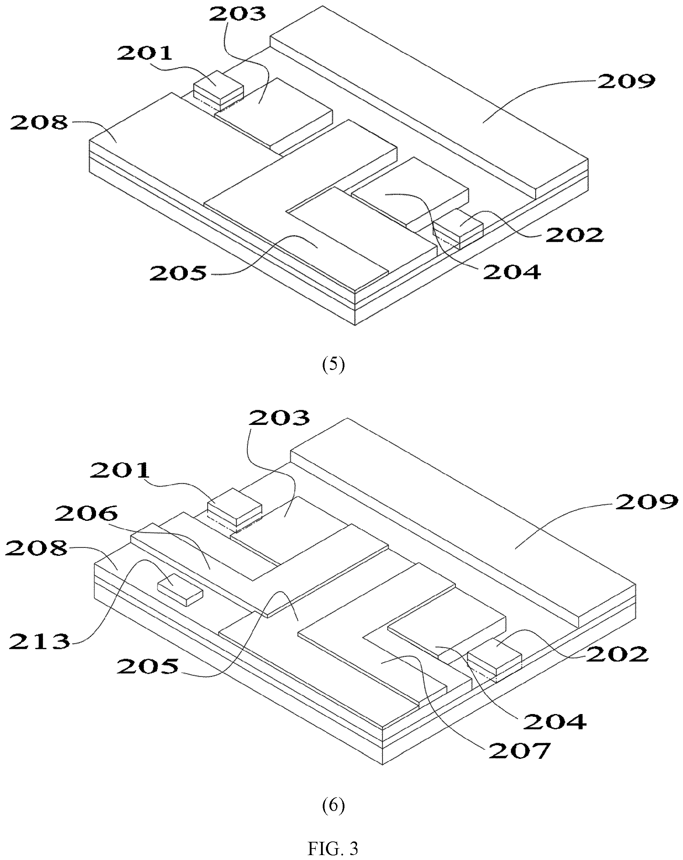

FIG. 2 is a flow chart of a fabrication method for a semiconductor quantum dot device provided in an embodiment of the present application, and FIG. 3 is a schematic structural illustration corresponding to each process step in the flow chart of FIG. 2.

As shown in FIG. 2 and FIG. 3, this embodiment provides a fabrication method for a semiconductor quantum dot device, including:
S110: forming a first ion region 103 and a second ion region 104 on the silicon substrate 101;
As shown in FIG. 3 (1), a first ion region 103 and a second ion region 104 that are symmetrical are formed on a silicon substrate by photolithography and etching processes, wherein the first ion region 103 and the second ion region 104 are symmetrical about the same horizontal line on the silicon substrate 101.

S120: forming a dielectric layer 102 located on the silicon substrate 101, with a carrier channel formed at an interface between the silicon substrate and the dielectric layer;
As shown in FIG. 3 (2), after the first ion region 103 and the second ion region 104 are fabricated on the silicon substrate 101, the dielectric layer 102 can be formed above the silicon substrate 101, that is, a carrier channel can be formed at a contacting interface between the silicon substrate 101 and the dielectric layer 102.

S130: forming a first electrode 201 in ohmic contact with the first ion region 103, and a second electrode 202 in ohmic contact with the second ion region 104;
As shown in FIG. (3), photolithography, etching and metal plating processes are adopted to form the first electrode 201 in ohmic contact is formed on the first ion region 103, and the second electrode of ohmic contact is formed on the second ion region 104. Specifically, the first ion region 103 and the second ion region 104 can be used for storing and outputting electrons. Here, outputting electrons requires a current between the first ion region 103 and the second ion region 104. The first electrode 201 and the second electrode 202 are configured to apply the first DC bias voltage, so as to form a current (that is, the carrier channel current) between the first ion region 103 and the second ion region 104.

S140: forming a confining electrode located on the dielectric layer 102, the confining electrode being configured to confine carriers within the carrier channel to form quantum dots;

As shown in FIG. 3 (5) and FIG. 3 (6), the confining electrode includes a first guiding electrode 203, a second guiding electrode 204, a first pumping electrode 205, a second pumping electrode 206 and a third pumping electrode 207. Specifically, first of all, the first guiding electrode 203 and the second guiding electrode 204 are fabricated between the first electrode 201 and the second electrode 202 on the dielectric layer 102. The processing method for the first guiding electrode 203 and the second guiding electrode 204 is the same as that for forming the first electrode 201 or the second electrode 202. Then, the first pumping electrode 205 is fabricated between the first guiding electrode 203 and the second guiding electrode 204 using the same processing method. Here, the first electrode 201, the second electrode 202, the first guiding electrode 203, the second guiding electrode 204 and the first pumping electrode 205 are arranged along the same horizontal direction of the dielectric layer 102 .

In addition, after the first guiding electrode 203, the second guiding electrode 204, and the first pumping electrode 205 are formed on the dielectric layer 102, an insulating layer needs to be formed on the surface thereof, so as to isolate the electrodes from each other. Specifically, the method for forming the insulating layer may include in-situ thermal oxidation, plasma oxidation, or growth by electron deposition.

S150: forming a magnetic electrode 213, the magnetic electrode 213 being configured to form a magnetic field gradient at the interface and to receive microwave signals for manipulating the quantum dots.

After fabricating, on the dielectric layer, the first electrode 201 and the second electrode 202 configured to form the carrier channel current and the confining electrode configured to confine the movement and quantity of electrons, corresponding quantum dots can be generated under the confining electrode. When manipulating the quantum dots, the manipulating needs to be completed by applying an external magnetic field, and therefore it is also necessary to form a magnetic electrode 213 on the quantum dot device. Specifically, the magnetic electrode 213 can be shaped by electron beam lithography, and can be formed by an electron beam evaporation coating process. The magnetic electrode 213 can be fabricated on the dielectric layer 102 or on the silicon substrate 101; the fabrication process therefor is simple, and the integration thereof is easy.

The fabrication method for a semiconductor quantum dot device provided in the second aspect of the present application can fabricate the semiconductor quantum dot device provided in the first aspect of the present application.

### Embodiment 3

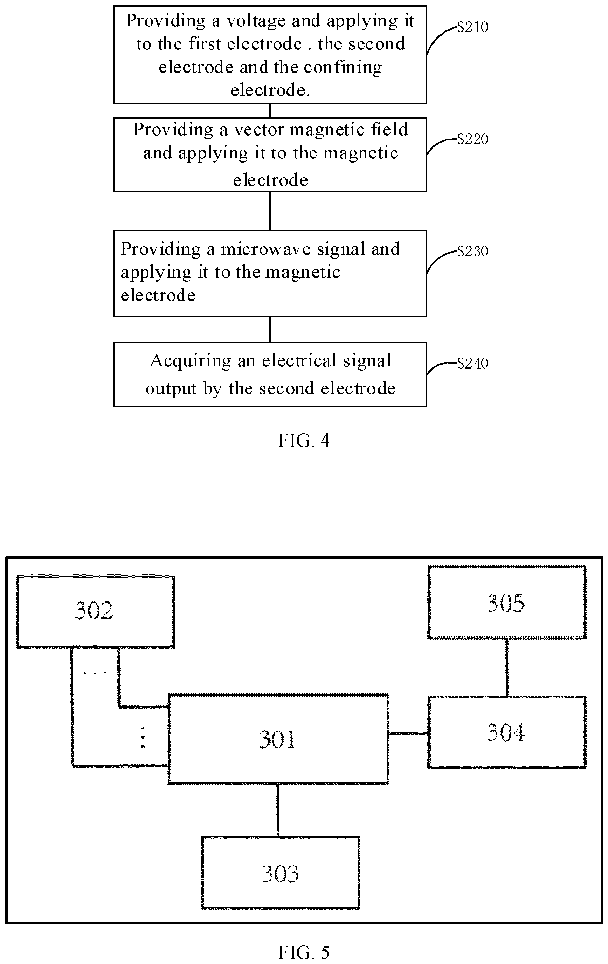

FIG. 4 is a flowchart of a signal reading method for a semiconductor quantum dot device provided in an embodiment of the present application, and FIG. 5 is a schematic structural illustration of a signal reading system for a semiconductor quantum dot device provided in an embodiment of the present application.

As shown in FIG. 4 and FIG. 5, this embodiment provides a signal reading method for a semiconductor quantum dot device, which specifically includes:
Step S210 : providing a voltage and applying it to the first electrode 201 , the second electrode 202 and the confining electrode.

Specifically, first of all, apply a second DC bias voltage to the first guiding electrode 203 and the second guiding electrode 204 to form a carrier channel, and then apply the first DC bias voltage to the first electrode 201 and the second electrode 202 to form a current in the carrier channel. Then, a third DC bias voltage is applied on the gate electrode 206 and the gate electrode 207, such that the second quantum dot 210, the first quantum dot 211 and the third quantum dot 212 are formed right under the pump electrode 205, the gate electrode 206 and the gate electrode 207. The second quantum dot 210 , the first quantum dot 211 and the third quantum dot 212 formed at this time each has multiple energy levels (called valley energy levels), and the energy levels can be selected. Here, the first DC bias voltage, the second DC bias voltage, and the third DC bias voltage can be adjusted in real time according to the performance parameters of the quantum dots during specific implementation.

Step S220 : providing a vector magnetic field and applying it to the magnetic electrode 213.

After the second quantum dot 210, the first quantum dot 211 and the third quantum dot 212 are formed on the substrate in the step S210, the second quantum dot 210, the first quantum dot 211 and the third quantum dot 210 can be manipulated by applying a magnetic field signal. Specifically, any valley energy level of each quantum dot is in a degenerating state, that is, to have both spin-up electrons and spin-down electrons. In conjunction with the principle of energy level splitting in quantum physics, it can be seen that, when a magnetic field signal is applied to a quantum dot, the valley energy level of the quantum dot will undergo Zeeman splitting; that is, a valley energy level will be split into a high energy level consisting of spin-up electrons and a low energy level consisting of spin-down electrons, where each energy level can be set as an eigenstate (such as the ground state and excited state) of one quantum dot.

It can be expected that when a quantum dot itself has a plurality of valley energy levels, under the action of an appropriate magnetic field, each valley energy level will undergo Zeeman splitting and split into two energy levels (that is, a high energy level and a low energy level). Both the high energy level and the low energy level formed by energy level splitting are energy levels with a single spin direction. When two quantum dots are used, measurement of a single quantum dot can be realized in conjunction with the Pauli Exclusion Principle. Here, the Pauli Exclusion Principle can be simply summarized as: electrons in the same motion state (spin up or spin down) cannot be accommodated in an atom, that is, there cannot be, in one energy level, two electrons that are both spin-up or both spin-down.

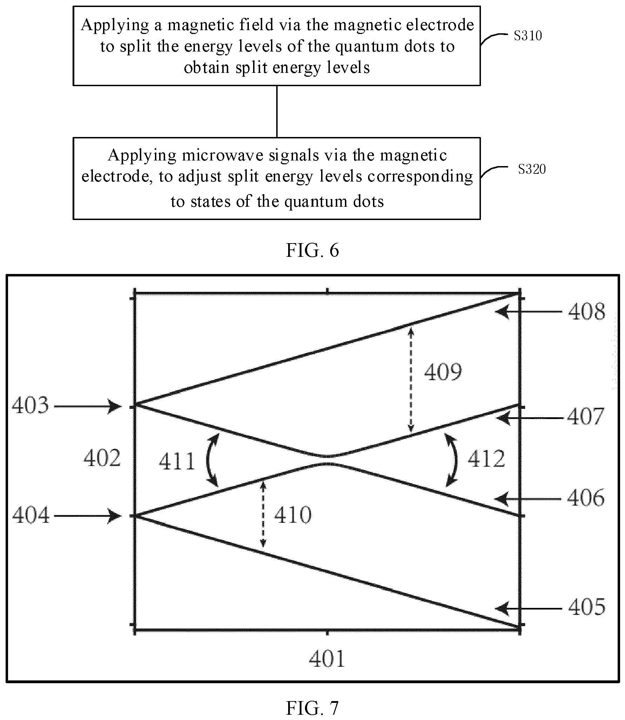

Fig. 7 is a schematic illustration of energy level splitting of a semiconductor quantum dot device provided in an embodiment of the present application under the action of a magnetic field. Referring to Fig. 7, taking the second quantum dot 210 as an example for illustration: 403 and 404 in the figure are valley energy levels of the second quantum dot 210 itself, when a varying magnetic field signal is applied, both the valley energy levels 403 and 404 undergo Zeeman splitting, wherein the valley energy level 403 undergoes Zeeman splitting to form 407 (spin down) and 408 (spin up), and at the same time, the valley energy level 404 undergoes Zeeman splitting to form 405 (spin down) and 406 (spin up). Accordingly, the second quantum dot 210 now has four energy levels, i.e., 405, 406, 407, and 408.

It can be seen from FIG. 7 that there are energy level differences between adjacent energy levels. Specifically, the energy level difference between the energy levels 405 and 406 is the energy level difference produced by the Zeeman splitting of the quantum dot 410; the energy level difference between the 407 and 408 is the valley energy level difference of the quantum dot 410; and there are two energy level differences 411 and 412 between the energy level 406 and the energy levels 407. It can be found that the energy level differences 411 and 412 are the energy level differences after mixing the valley energy level with the spin energy level, and are also known as mixed energy level systems. With the increasing of the applied magnetic field, the energy level differences 410, 411 and 412 will also vary correspondingly.

Here, interaction may occur between the energy level 407 (spin down) and the energy level 406 (spin up), and electrons in this energy level may transform into each other in the case that the energy requirements are met. As such, there may be the situation as shown in FIG.7 where the energy level 407 and the energy level 406 do not intersect (which can be understood as anti-crossing). Especially in an anti-crossing region, it is easier to realize interaction and transition between energy levels. It can be further understood that the mixed energy level systems are easier to control, that is, spin resonance can be efficiently realized through electrical manipulation, and realizing response of a corresponding qubit.

Step S230 : providing a microwave signal and applying it to the magnetic electrode 213.

When the energy level of the quantum dot is split by applying a magnetic field signal to generate multiple energy levels, there are energy level differences between the energy levels, such as the energy level differences 410, 411, 412 of the second quantum dot 210 in the above example. In physics, spin of an electron can be manipulated by applying a microwave electric field. Taking the mixed energy level systems 411 and 412 as an example, the mixed valley energy level differences both include the energy level 407 occupied by spin-up electrons and the energy level 406 occupied by spin-down electrons. When microwave signals are applied and frequencies of the microwave signals are identical to or close to the mixed energy level systems 411 and 412, resonance will occur, causing the spin directions of the electrons on the energy level 406 and energy level 407 to change. This principle can refer to use of electric dipole spin resonance in order to enable manipulation of electron spins.

Here, use of electric dipole spin resonance can realize manipulation of a single quantum dot. In practical applications, by adding auxiliary quantum dots, the state of a manipulated quantum dot can be read, that is, to read the state of the qubit, which is of great significance in the field of quantum computing.

Taking the second quantum dot 210 and the first quantum dot 211 as an example, wherein the first quantum dot 211 can be used as an auxiliary quantum dot, and wherein the electron spin direction in the auxiliary quantum dot is set to be known (such as spin-down). In conjunction with the description of step S20 and step S30, the energy level of the first quantum dot 210 is split by applying a magnetic field signal, and microwave signals are applied via the magnetic electrode 213 to control spin of the electrons in the first quantum dot 210. As such, the original spin state of electrons in the first quantum dot 210 can be measured according to the physical mechanism of Pauli Exclusion. Simply put, when the spin direction of the electrons in the first quantum dot 210 is spin-down, the spin direction of the electrons in the second quantum dot 210 is changed to spin-up by applying electric dipole spin resonance of the microwave signals, and the preset auxiliary quantum dot (the first quantum dot 211) is spin-down, and the variation of the output current can be measured. Otherwise, when the spin direction of the electrons in the second quantum dot 210 is spin-up, the spin direction of the electrons in the second quantum dot 210 is changed to spin-down by applying electric dipole spin resonance of the microwave signals, then at this time, electrons cannot pass through the energy level of the first quantum dot 211, i.e., the measured output current does not vary.

Step S240: Acquiring an electrical signal output by the second electrode 202.

Referring to the measurement described in step S230, variation of the output current of the auxiliary quantum dot can be tested by a signal testing device. In a specific quantum dot device, the current of the drain (the second electrode 202 in this application) can be measured by an ammeter or a voltmeter.

By using two quantum dots and applying magnetic field signals and microwave signals through the magnetic electrode 213, reading of a single quantum dot can be realized; and when it is designed as a qubit, the quantum state of the qubit can be effectively read.

### Embodiment 4

FIG. 6 is a flowchart of a manipulation method for a semiconductor quantum dot device provided in an embodiment of the present application, and FIG. 7 is a schematic illustration of energy level splitting of a semiconductor quantum dot device provided in an embodiment of the present application under the action of a magnetic field.

As shown in FIG. 6 and FIG. 7, this embodiment provides a manipulation method for a semiconductor quantum dot device, which specifically includes:
Step S310: applying a magnetic field via the magnetic electrode 213 to split the energy levels of the quantum dots to obtain split energy levels;
wherein, the split energy levels include a first valley spin energy level, a second valley spin energy level, a third valley spin energy level and a fourth valley spin energy level, wherein the second valley spin energy level and the third valley spin energy level are anti-crossing;
Specifically, the splitting effect is shown in FIG. 7. The quantum dot has a spin energy level and a valley energy level , wherein the valley energy level is the natural energy level of the silicon-based quantum dot and has a plurality of energy levels, such as valley energy levels 403 and 404 in FIG. 7. On the other hand, the spin energy levels require application of a magnetic field so as to split and form two energy levels, i.e., spin-up and spin-down. After the Zeeman splitting occurs in the quantum dot, the valley energy levels and the spin energy levels are mixed to form split energy levels 405 (the first valley spin level), 406 (the second valley spin level), 407 (the third valley spin level), and 408 (the fourth valley spin level).

Taking the second quantum point 210 as an example, the valley energy level 403 is a high energy level, the valley energy level 404 is a low energy level, wherein the valley energy level 403 undergoes Zeeman splitting under the action of a magnetic field to form split energy levels 408 (electrons spin-up) and 409 (electrons spin-down), and the valley energy level 404 undergoes Zeeman splitting under the action of a magnetic field to form split energy levels 406 (electrons spin-up) and 405 (electrons spin-down)_{∘}

Specifically, the energy level difference between the valley energy levels 403 and 404 is an intrinsic property of the silicon-based quantum dot, and is under the influences of its own properties. On the other hand, after Zeeman splitting occurs under the action of an applied external magnetic field, the Zeeman split energy levels formed is related to the magnitude of the applied external magnetic field. For example, the energy level difference 410 between the split energy levels 405 and 406 as shown in FIG. 7 increases with the enhancing of magnetic field.

Not only will there be a split energy level difference 410 between the split energy levels 405 and 406, there will also be split energy level differences 411 and 412 between the split energy levels 406 and 407 (hybrid energy level system), where the split energy level differences 411 and 412 are split energy level differences after mixture of the valley energy levels with the spin energy levels. In addition, there is an energy level difference 409 between the split energy levels 407 and 408, which is a valley energy level difference and is related to intrinsic properties of the silicon substrate 101.

Here, the spin energy level 407 and the spin energy level 406 can be used as the eigenstate (excited state and ground state) of the qubit, therefore, the mixed energy level systems 411 and 412 between the spin energy level 407 and the spin energy level 406 are objects for controlling the qubit. Specifically, electrons between the mixed energy level systems 411 and 412 can be made to produce spin resonance through applied microwave signals.

Step S320: applying microwave signals via the magnetic electrode 213, to adjust split energy levels corresponding to states of the quantum dots.

wherein, the frequency of the microwave signal corresponds to the transition energy between the second valley spin level and the third valley spin level.

After the mixed energy level systems 411 and 412 are formed, microwave signals can be applied through the magnetic electrode 213 to control the mixed energy level systems 411 and 412. The specific control method is the aforementioned electric dipole spin: when the frequency of the microwave signal applied by the electrode 213 corresponds to the transition energy between the second valley spin energy level (406) and the third valley spin energy level (407), that is, to resonate with the mixed energy level systems 411 and 412, then electrons will transition between spin levels 406 and 407. Corresponding to the qubit, that is, the quantum state of the qubit is changed by applying a microwave signal.

In semiconductor quantum dot devices, both the valley energy level and the electron spin energy level can select two lowest energy levels among all the energy levels to be designed as qubits, which are characterized as the eigenstates of the qubits. Here, after using the valley energy level to design the eigenstate of the qubit, the decoherence time is relatively short as compared with the eigenstate of the qubits designed via the electron spin levels, which limits manipulation time on the qubits, i.e., greatly limits efficiency of quantum computing operations. Therefore, the valley energy levels are not widely adopted as the eigenstates designed as the qubits. In the prior art, electron spin levels are generally selected as eigenstates of qubits.

Although the qubits designed through the electron spin levels enjoy longer decoherence times, manipulation thereof becomes more difficult for the following reasons: after the Zeeman splitting occurs under the action of a magnetic field, since differences between the spin levels after the splitting are quite large, then microwave signals to be applied for resonance with the spin level differences also increase. The mixed energy level systems can respond quickly to the applied microwave signals, and facilitates improving of the efficiency of electrical manipulation.

### Embodiment 5

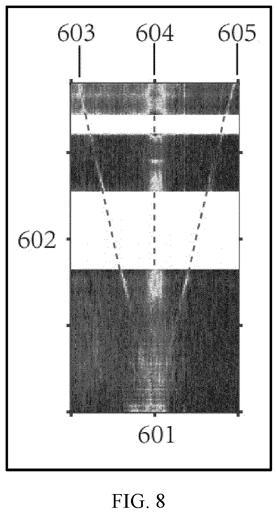

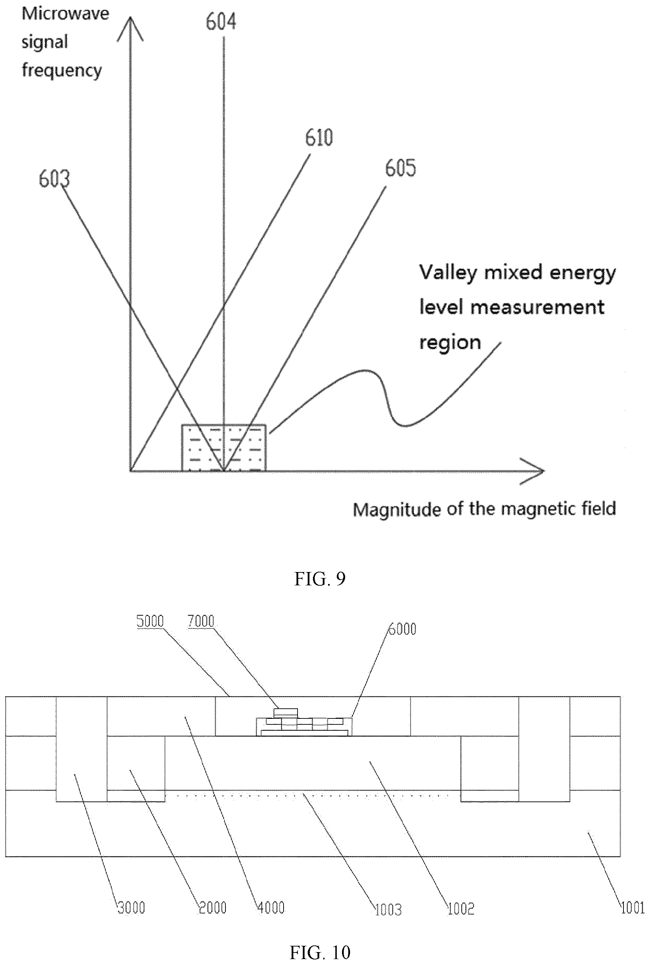

FIG. 8 and FIG. 9 are illustrations showing the electrical manipulation effects of a semiconductor quantum dot device provided in an embodiment of the present application.

As shown in FIG. 8 and FIG. 9, this embodiment provides an example of the electrical manipulation effects on a semiconductor quantum dot device based on valley spin mixed energy levels, wherein the semiconductor quantum dot device is the semiconductor quantum dot device in Embodiment 1, or it is the semiconductor quantum dot device fabricated according to the method of Embodiment 2.

Taking the second quantum dot 210 as an example, the current signal is measured via the second electrode 202. Specifically, the abscissa is the magnetic field gradient applied by the micro-magnet, and the ordinate is the frequency of the microwave signal applied by the micro-magnet. In addition, the depth (brightness) in the figure represents the magnitude of the current.

Here, the dotted line 603 indicates an electric current variation curve of the mixed energy level system 411 under control of a magnetic field and microwave signals, as measured via the second electrode 202; the dotted line 605 indicates an electric current variation curve of the mixed energy level system 412 under control of a magnetic field and microwave signals, as measured via the second electrode 202. In addition, the dotted line 604 indicates an electric current variation curve when the spin energy level difference and the valley energy level difference are identical, as measured via the second electrode 202.

As shown in FIG. 9, as a comparison, 610 indicates an electric current variation curve of the spin energy level difference 410 under control of a magnetic field and microwave signals, as measured via the second electrode 202. The microwave signal that 610 needs to apply is much larger than the control range of the mixed energy level systems 411 and 412. This can be understood as a very poor result of control on the spin energy level difference 410 by microwave signals. Further, it can be interpreted that: if the spin energy level difference 410 is used as the eigenstate of the qubit, during control of quantum states of a qubit, it cannot be read unless a very large microwave signal is applied, which increases the difficulty of control.

On the contrary, when the mixed energy level systems 411 and 412 are used, they have a strong control capability in response to microwave signals, that is, when they are used as eigenstates of qubits, they are easy to control during quantum computing operations.

A third aspect of the present application provides a manipulation method for a semiconductor quantum dot device, which method forms, via a magnetic electrode 213, a magnetic field gradient so as to split a valley energy level of the quantum dots and obtain split energy levels, and applies microwave signals via the magnetic electrode 213 to adjust energy level transitions between the split energy levels, so as to implement manipulation of states of the quantum dots. Compared with traditional control between spin energy levels, states of quantum dots in the present application are adjusted between the split energy levels, and has the advantage of fast manipulation speed. As a result, the present application is relatively strong in the manipulation capability of electric fields.

### Embodiment 6

As shown in FIG. 5 , this embodiment provides a signal reading system based on a mixed-level semiconductor quantum dot device. The system includes a semiconductor quantum dot device 301, a DC bias voltage source 302, a microwave source 303, a signal amplifier 304 and a voltage testing device 305; wherein the semiconductor quantum dot device is the semiconductor quantum dot device in Embodiment 1, or is the semiconductor quantum dot device fabricated according to the method of Embodiment 2.

The DC bias voltage source 302 is connected to the first electrode 201, the second electrode 202, the first guiding electrode 203, the second guiding electrode 204 and each confining electrode of the semiconductor quantum dots. It is used for providing a DC bias voltage, specifically including: the DC bias voltage applied on the first electrode 201 and the second electrode 202 of the semiconductor quantum dot device for generating the carrier channel; the forward bias voltage applied on the first guiding electrode 203 and the second guiding electrode 204 for forming a current in the carrier channel; and the bias voltage applied on the confining electrode for forming quantum dots.

The microwave source 303 is connected to the magnetic electrode 213 of the semiconductor quantum dot device, and is configured to provide a microwave signal whose frequency resonates with the mixed energy level systems 411 and 412 so as to realize control of the semiconductor quantum dot device 301.

The signal amplifier 304 is connected to the second electrode 202 (i.e., the drain) of the semiconductor quantum dot device, and is configured to amplify the signal output via the drain of the semiconductor quantum dot device. Specifically, a current signal is output from the semiconductor quantum dot, which current signal is first converted into a voltage signal, and then the converted voltage signal is amplified, and the amplified voltage signal is output for testing.

The voltage testing device 305 is connected to the signal amplifier 304, and is configured for testing the amplified voltage signal. Then, the quantum state of the semiconductor quantum dot device is analyzed through the test results.

In addition, this embodiment also proposes a quantum computer, including a semiconductor quantum dot device described in the above embodiments, or a semiconductor quantum dot device fabricated according to the method described in the above embodiments, or including a semiconductor quantum dot device described in the above embodiments, or a semiconductor quantum dot device manipulated according to the method in the above embodiments, or a semiconductor quantum dot device for signal reading according to the signal reading method described in the above embodiments.

Compared with the prior art, the semiconductor quantum dot device provided by the first aspect of the present application forms, via the magnetic electrode 213, a magnetic field gradient at the interface, and the magnetic electrode 213 can vary the magnetic field gradient at the interface between the silicon substrate and the dielectric layer according to the magnetic field intensity vector applied to the semiconductor quantum dot device, thereby splitting the valley energy level of the carriers at the quantum dots, and thus obtaining split energy levels suitable for electrical manipulation via microwave signals applied to the magnetic electrode. Compared with structures such as antennas, the magnetic electrode 213 used in the present application is relatively small, having structural advantages facilitating its integration.

Compared with the prior art, the fabrication method for a semiconductor quantum dot device provided in the second aspect of the present application can fabricate the semiconductor quantum dot device provided in the first aspect of the present application.

Compared with the prior art, the manipulation method for semiconductor quantum dot devices provided in the third aspect of the present application forms, via a magnetic electrode 213, a magnetic field gradient so as to split a valley energy level of the quantum dots and obtain split energy levels, and applies microwave signals via the magnetic electrode 213 to adjust energy level transitions between the split energy levels, so as to implement manipulation of states of the quantum dots. Compared with traditional control between spin energy levels, states of quantum dots in the present application are adjusted between the split energy levels, and has the advantage of fast manipulation speed. As a result, the present application is relatively strong in the manipulation capability of electric fields.

### Embodiment 7

FIG. 10 is a schematic cross-sectional view of the overall structure of a semiconductor quantum dot device provided in an embodiment of the present application.

As shown in FIG. 10, the present embodiment provides a semiconductor quantum dot device structure, including: a silicon substrate 1001; a silicon dioxide layer 1002 located on the silicon substrate 1001, with an ion implantation window 2000 formed on the silicon dioxide layer 1002, wherein the ion implantation window 2000 is configured to implant ions into the silicon substrate 1001; a first insulating layer 4000 located on the silicon dioxide layer 1002, with ohmic electrodes 3000 formed on the first insulating layer 4000, the ohmic electrodes 3000 being in ohmic contact with implanted ions; a quantum dot window located on the silicon dioxide layer, the quantum dot window being located between the ohmic electrodes and exposing the silicon dioxide layer; and a first metal electrode 6000 and a magnet 7000 located in the quantum dot window 5000, wherein the first metal electrode 6000 is arranged in a stacked way, the first metal electrode 6000 is configured to form quantum dots, and the magnet 7000 is configured to control the quantum dots.

In the field of semiconductor quantum dot fabrication, formation of quantum dots and manipulation of quantum dots need to be realized with the help of a plurality of electrodes, such as channel electrodes, ohmic electrodes, and gate electrodes. In the process of forming quantum dots, first of all it is necessary to form a carrier channel that can be activated by a electric field (that is, the two-dimensional carrier channel 1003), and in the carrier channel, an electric field is applied through the electrodes to control the number of electrons, thereby forming quantum dots containing only a small amount of electrons.

Specifically, as shown in FIG. 10 , the silicon substrate 1001 can be an undoped intrinsic silicon substrate, and then a silicon dioxide layer 1002 is formed on the silicon substrate 1001 by dry oxidation or electron deposition. An ion implantation window 2000 is formed on the silicon dioxide layer 1002; through the ion implantation window 2000, ions are implanted into the silicon substrate 1001. A first insulating layer 4000 is formed on the silicon dioxide layer 1002, and ohmic electrodes 3000 (3001, 3002, 3003, 3004) in ohmic contact with implanted ions on the silicon substrate 1001 can be formed on the first insulating layer 4000. Specifically, when forming the ohmic electrode, it is necessary to expose the ohmic contact window on the first insulating layer 4000 so as to etch off the silicon dioxide layer in the ohmic contact window, and further expose and etch the silicon dioxide layer to expose the intrinsic silicon layer. Further, metal is deposited via atomic deposition technology at the locations where the intrinsic silicon layer is in contact with the implanted ions, to form an ohmic electrode on the first insulating layer.

In addition, on the first insulating layer 4000, a quantum dot window 5000 is also formed between the ohmic electrodes 3000. Here, the quantum dot window 5000 is a region formed on the surface of the first insulating layer 4000 through process flows such as exposure, development, and etching, so that the silicon dioxide layer in the quantum dot window is exposed. Furthermore, a stacked first metal electrode 6000 (that is, gate electrodes 6001, 6002, and 6003) is formed in the quantum dot window 5000. That is, the first metal electrode 6000 is formed at the surface of the silicon dioxide layer 1002 in the quantum dot window 5000. Through the ohmic electrode 3000 and the first metal electrode 6000, quantum dots can be formed in the quantum dot window 5000. In addition, a magnet 7000 for controlling the quantum dots is also provided in the quantum dot window 5000.

Continue to refer to FIG. 10, in the field of semiconductor quantum dot devices, the formation and control of quantum dots needs to be controlled by a plurality of gate electrodes (that is, the first metal electrode 6000), and formed in the way of electric field trapping. Generally speaking, formation of each quantum dot requires cooperation of a plurality of first metal electrodes 6000. During the implementation of this application, the first metal electrode 6000 is fabricated in the form of lamination, that is, a plurality of first metal electrodes 6000 are formed on different horizontal planes, interlacing with each other. Electric field control on the quantum dots via the first metal electrode 6000 may be made more precise through the preset size of the first metal electrode and relative positions of the different planes thereof.

The semiconductor quantum dot device of the present application provides a region for carrier to pass by using a stacked structure of a silicon substrate 1001 and a silicon dioxide layer 1002; produces quantum dots via the ohmic electrode 3000 located in the first insulating layer 4000 and the first metal electrode 6000 in the quantum dot window 5000, and control the quantum dots via electric fields; and controls the states of the quantum dots via the magnet 7000 in the quantum dot window 5000, so as to perform quantum computing. Moreover, the first metal electrodes 6000 in the quantum dot window 5000 are formed in the form of stacked layers, that is, a plurality of first metal electrodes 6000 are formed in different horizontal planes and are interlaced with each other. Electric field control on the quantum dots via the first metal electrode 6000 may be made more precise through the preset size of the first metal electrode and relative positions of the different planes thereof.

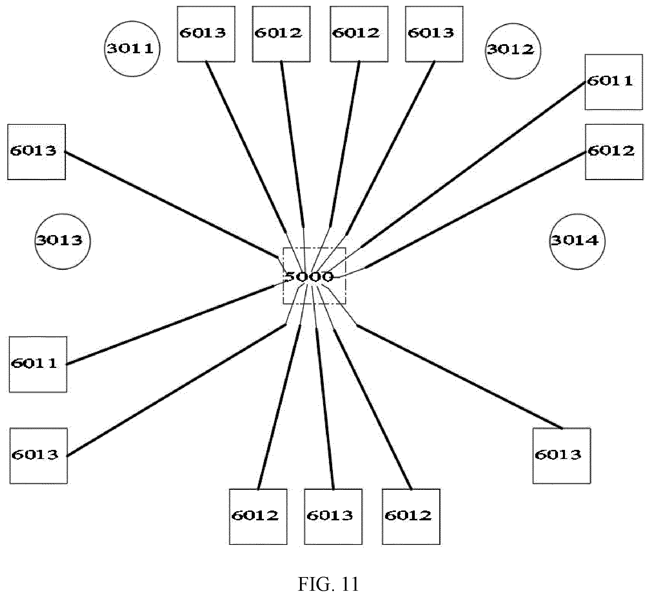

As shown in FIG. 11, as an implementation of the embodiment of the present application, a second metal electrode (such as 6011, 6012, 6013) is also formed on the first insulating layer 4000, and the second metal electrode (that is, 6011, 6012, 6013) is electrically connected to the first metal electrode 6000 (that is, 6001, 6002, 6003) in one-to-one correspondence, wherein the second metal electrode is located outside the quantum dot window 5000, and is configured to transmit a received voltage control signal to the first metal electrode 6000.

The first metal electrode 6000 is located in the quantum dot window 5000 and is for forming and controlling quantum dots, and is of a very small size. In addition, since various bias voltage signals needs to be applied on the first metal electrode 6000 to provide an electric field, it is necessary to connect various signal source devices. Therefore, second metal electrodes (such as a chip pin, a pad on a PCB, etc.) are provided on the first insulating layer, and is electrically connected to each of the first metal electrodes 6000 in one-to-one correspondence. The size of the second metal electrode is larger than that of the first metal electrode 6000, which is convenient for transmitting a received voltage control signal to the first metal electrode 6000 in the quantum dot window 5000, for forming and controlling quantum dots.

### Embodiment 8

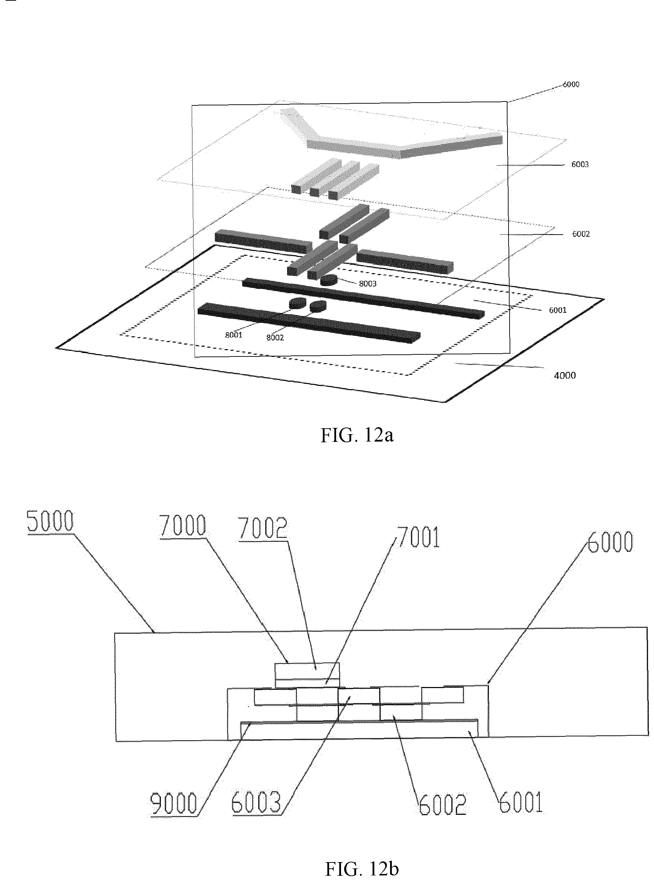

Fig. 12a and Fig. 12b are schematic illustrations of stacking layers of a first metal electrode 6000 provided by the present application. As an implementation manner of the embodiment of the present application, the first metal electrode 6000 includes:
First metal sub-electrodes 6001, arranged in parallel in the quantum dot window 5000, and the first metal sub-electrodes 6001 are configured to form channels; second metal sub-electrodes 6002, located on the first metal sub-electrodes 6001, and are configured to form quantum dots in the channels; third metal sub-electrodes 6003, located on the second metal sub-electrodes 6002, and are configured to adjust coupling parameters of the quantum dots; wherein, second insulating layers 9000 are formed between the first metal sub-electrodes 6001 and the second metal sub-electrodes 6002, and between the second metal sub-electrodes 6002 and the third metal sub-electrodes 6003.

Specifically, first of all, the first metal sub-electrodes 6001 are formed in the quantum dot window 5000 on the silicon dioxide layer 1002 through exposure, development, and coating processes. The first metal sub-electrodes 6001 being a channel electrode. As is well known in the field of semiconductors, a channel refers to the semiconductor layer between the source and the drain in a transistor, which is arranged in parallel in the quantum dot window 5000 and also arranged in parallel with the ohmic electrode 3000 during implementation of the present application. By providing the first metal sub-electrodes 6001 in the quantum dot window 5000, a channel is formed between the first metal sub-electrodes 6001. The channel corresponds to the carrier channel, and the channel is arranged along the horizontal direction of the ohmic electrode 3000 in the quantum dot window 5000. When a DC bias voltage is applied to the second metal sub-electrodes 6002 to form a current in the carrier channel, the carrier channel is in the channel region, that is to say, the electrons move in the channel.

Then, second metal sub-electrodes 6002 are formed above the first metal sub-electrode 6001, using the same process flow as that of the first metal sub-electrodes 6001. Here, the second metal sub-electrodes 6002 include lateral electrodes formed between the first metal sub-electrodes 6001 and arranged parallel to the first metal sub-electrodes 6001, and longitudinal electrodes arranged vertically to the first metal sub-electrodes 6001. The lateral electrodes are configured to form a two-dimensional carrier channel 1003 in the channel by applying a DC bias voltage, which can be understood as source and drain electrodes. Furthermore, a bias voltage can be applied to form a current through the ohmic electrode 3000. The longitudinal electrodes are configured to evacuate most of the electrons in the current by applying a bias voltage, only retaining a few electrons to form quantum dots (8001, 8002 and 8003 in the figure) in the two-dimensional carrier channel 1003 below it.

Further, third metal sub-electrodes 6003 are formed above the second metal sub-electrodes 6002. The third metal sub-electrodes 6003 are configured to adjust the electrons in the current by applying a bias voltage, which is similar to the longitudinal electrodes in the second metal sub-electrodes 6002 and are configured to adjust the number of electrons in the current. Parameters of the quantum dots may be made more precise parameters by applying a bias voltage through the third metal sub-electrodes 6003 and the second metal sub-electrodes 6002 to jointly adjust the number of electrons.

It should be further noted that since the first metal sub-electrodes 6001, the second metal sub-electrodes 6002, and the third metal sub-electrodes 6003 are arranged in layers and are all metal conductors; therefore, when they are sequentially formed through processes such as exposure, development, and coating, second insulating layers 9000 need to be formed between the first metal sub-electrodes 6001, the second metal sub-electrodes 6002, and the third metal sub-electrodes 6003, to isolate the first metal sub-electrodes 6001, the second metal sub-electrodes 6002, the third metal electrodes 6003 from each other to avoid short circuit and leakage.

As an implementation of an embodiment of the present application, the second metal sub-electrodes 6002 and the third metal sub-electrodes 6003 are arranged alternately in the horizontal direction. The coupling strength between the quantum dots formed under the third metal sub-electrodes 6003 can be adjusted by applying a bias voltage through the second metal sub-electrodes 6002, and the coupling strength between the quantum dots, the source, and the drain (that is, the lateral electrodes in the first metal sub-electrodes 6001) can also be adjusted, making the control of quantum dots more precise.

As an implementation of an embodiment of the present application, the materials of the first metal sub-electrode 6001, the second metal sub-electrode 6002 and the third metal sub-electrode 6003 are all aluminum, and the material of the second insulating layer 9000 is alumina oxide. In the field of semiconductor chip fabrication, the material of metal electrodes can be selected from aluminum, titanium, palladium, and the like. At the same time, the insulating layer on the surface is usually made of aluminum oxide, as the process thereof is simple. Therefore, the materials of the first metal sub-electrodes 6001, the second metal sub-electrodes 6002, and the third metal sub-electrodes 6003 in an embodiment of the present application are selected as aluminum. After forming aluminum metal electrodes through exposure, development, and coating processes, the metal electrodes are oxidized using an oxygen ion bombardment process to form a layer of aluminum oxide insulating layer on the surface of the metal electrode, the process thereof is simple and easy for fabrication.

As an implementation of the embodiment of the present application, the magnet 7000 is located above the third metal sub-electrodes 6003. Specifically, a second insulating layer 9000 is formed on the third metal sub-electrodes 6003, and the magnet 7000 is formed on the surface of the second insulating layer 9000 on the third metal sub-electrode 6003. The magnet 7000 is provided in the quantum dot window 5000, and the quantum dots are manipulated by applying microwave signals to the magnet 7000, so that measurement and computing applications based on the quantum dots can be realized.

As an implementation of an embodiment of the present application, the magnet 7000 includes a first metal layer 7001 and a second metal layer 7002, wherein the second metal layer 7002 is located on the first metal layer 7001. The magnet 7000 is also fabricated through the same process as the metal electrodes (exposure, development and coating), and therefore, when forming the magnet 7000, considering the adhesion stability of the magnet 7000 on the surface of the second insulating layer 9000, the magnet 7000 is provided as a double-layer metal structure, the second metal layer 7002 is configured to adhere to the surface of the second insulating layer 9000, and the first metal layer is configured to apply microwave signals to manipulate the quantum dots.

As an implementation of an embodiment of the present application, the material of the first metal layer is titanium, and the material of the second metal layer is cobalt. The first metal layer is configured to adhere to the surface of the second insulating layer 9000, and the second metal layer is configured to apply microwave signals to manipulate the quantum dots. The material of the magnet 7000 is not limited to cobalt, and may also be other magnetic materials such as iron and nickel.

Specifically, when forming the first metal layer and the second metal layer, as an implementation of an embodiment of the present application, the thickness of the first metal layer is 10 nm, and the thickness of the second metal layer is 250 nm. The size of the magnet 7000 is small, and the adhesion stability of the magnet 7000 can be ensured by using the first metal layer with a thickness of 10 nm. The second metal layer is configured to apply microwave signals to manipulate the quantum dots, and its size depends on the number of quantum dots and the properties of the qubits formed by the quantum dots. The thickness of the second metal layer can influence the manipulation effect on the qubits. During implementation, the number of fabricated quantum dots is 3, and the thickness of the second metal layer is 250 nm, thereby achieving the effect of controlling 3 quantum dots by one magnet 7000.

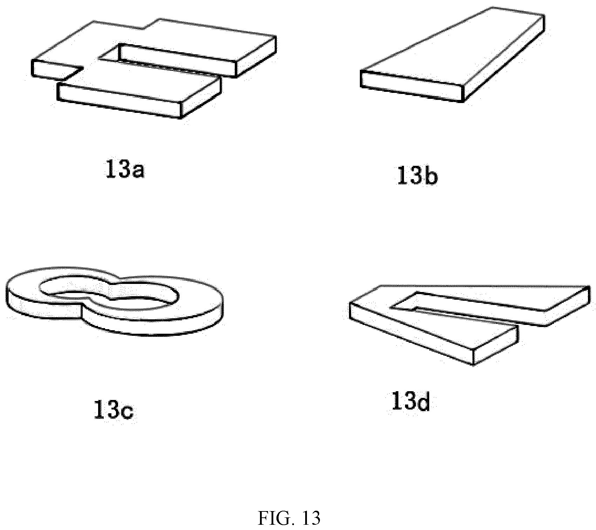

As shown in FIG. 13 , as an implementation of the embodiment of the present application, the shape of the magnet includes one of a trapezoid, a U-shape, and a ring-shape. The shape of the magnet can be various shapes, which are related to the positions of the first metal electrodes so as to ensure control of the quantum dots formed by the first metal electrodes.

The above has described in detail the structures, features and effects of the application based on the embodiments shown in the drawings. The above descriptions are only preferred embodiments of the application, and the application does not limit the scope of implementation to what is shown in the drawings. Any variations made according to the idea of the application or any modification as equivalent embodiments thereof that do not go beyond the spirit covered by the description and illustrations, shall be within the scope of protection of the application.

## Claims

1. A semiconductor quantum dot device, **characterized by** comprising:
a silicon substrate; and
a dielectric layer located on the silicon substrate.

2. The semiconductor quantum dot device of claim 1, **characterized by** comprising:
a silicon substrate formed to be provided with a first ion region and a second ion region;
a dielectric layer located on the silicon substrate, with a carrier channel formed at an interface between the silicon substrate and the dielectric layer;
a first electrode in ohmic contact with the first ion region, and a second electrode in ohmic contact with the second ion region;
a confining electrode located on the dielectric layer, configured to confine carriers within the carrier channel to form quantum dots; and
a magnetic electrode configured to form a magnetic field gradient at the interface and configured to manipulate the quantum dots.

3. The semiconductor quantum dot device of claim 1, **characterized by** comprising:
a silicon substrate;
a silicon dioxide layer located on the silicon substrate, with an ion implantation window formed on the silicon dioxide layer, wherein the ion implantation window is configured to implant ions into the silicon substrate;
a first insulating layer located on the silicon dioxide layer, with ohmic electrodes formed on the first insulating layer, the ohmic electrodes being in ohmic contact with implanted ions;
a quantum dot window located on the silicon dioxide layer, the quantum dot window being located between the ohmic electrodes and exposing the silicon dioxide layer; and
a first metal electrode and a magnet located in the quantum dot window, wherein the first metal electrode is arranged in a stacked way, the first metal electrode is configured to form quantum dots, and the magnet is configured to control the quantum dots.

4. The semiconductor quantum dot device of claim 2, wherein the dielectric layer is one of a silicon dioxide layer, a silicon-germanium heterojunction layer, and a nanowire material layer.

5. The semiconductor quantum dot device of claim 2 or 4, **characterized in that**, the confining electrode comprises a plurality of gate electrodes arranged in an overlapping way, and insulating layers are formed between adjacent gate electrodes.

6. The semiconductor quantum dot device of claim 2 or 5, **characterized in that**, the confining electrode comprises:
a first guiding electrode and a second guiding electrode, located between the first electrode and the second electrode;
a first pumping electrode located between the first guiding electrode and the second guiding electrode and arranged alternately with the first guiding electrode and the second guiding electrode; and
a second pumping electrode and a third pumping electrode, wherein the second pumping electrode is located between the first guiding electrode and the first pumping electrode, and the third pumping electrode is located between the second guiding electrode and the first pumping electrode.

7. The semiconductor quantum dot device of claim 6, **characterized in that**, the dielectric layer partially covers the first ion region and the second ion region, and wherein the first guiding electrode extends to cover part of the first ion region, and the second guiding electrode extends to cover part of the second ion region.

8. The semiconductor quantum dot device of any one of claims 2 and 4 to 7, **characterized in that** the magnetic electrode is an iron electrode or a cobalt electrode.

9. The semiconductor quantum dot device of any one of claims 2 and 4 to 8, **characterized by** further comprising a first channel electrode and a second channel electrode both located on the dielectric layer, wherein a one-dimensional channel is formed between the first channel electrode and the second channel electrode, and wherein the confining electrode, the first electrode and the second electrode are all located in the one-dimensional channel.

10. The semiconductor quantum dot device of claim 3, wherein a second metal electrode is also formed on the first insulating layer, and the second metal electrode is electrically connected to the first metal electrode in one-to-one correspondence, wherein, the second metal electrode is located outside the quantum dot window, and is configured to transmit a received voltage control signal to the first metal electrode.

11. The semiconductor quantum dot device of claim 3 or 10, wherein the first metal electrode comprises:
first metal sub-electrodes, arranged in parallel in the quantum dot window, and are configured to form channels;
second metal sub-electrodes, located on the first metal sub-electrodes, and are configured to form quantum dots in the channels;
third metal sub-electrodes, located on the second metal sub-electrodes, and are configured to adjust coupling parameters of the quantum dots;
wherein, second insulating layers are formed between the first metal sub-electrodes and the second metal sub-electrodes, and between the second metal sub-electrodes and the third metal sub-electrodes.

12. The semiconductor quantum dot device of claim 11, wherein the second metal sub-electrodes and the third metal sub-electrodes are arranged alternately in a horizontal direction.

13. The semiconductor quantum dot device of claim 11, wherein the first metal sub-electrodes, the second metal sub-electrodes and the third metal sub-electrodes are all made of aluminum, and the second insulating layers are made of alumina oxide.

14. The semiconductor quantum dot device of claim 11, wherein the magnet is located above the third metal sub-electrodes.

15. The semiconductor quantum dot device of any one of claims 3 and 10 to 14, **characterized in that** the magnet comprises a first metal layer and a second metal layer, wherein the second metal layer is located on the first metal layer.

16. The semiconductor quantum dot device of claim 15, **characterized in that** the first metal layer is made of titanium, and the second metal layer is made of cobalt .

17. The semiconductor quantum dot device of claim 16, wherein a thickness of the first metal layer is 10 nm, and a thickness of the second metal layer is 250 nm.

18. The semiconductor quantum dot device of any one of claims 3 and 10 to 17, wherein the magnet is of one of the following shapes: a trapezoid, a U-shape, and a ring-shape.

19. A fabrication method for a semiconductor quantum dot device, **characterized by** comprising:
forming a first ion region and a second ion region on a silicon substrate;
forming a dielectric layer located on the silicon substrate, with a carrier channel formed at an interface between the silicon substrate and the dielectric layer;
forming a first electrode in ohmic contact with the first ion region, and a second electrode in ohmic contact with the second ion region;
forming a confining electrode located on the dielectric layer, the confining electrode being configured to confine carriers within the carrier channel to form quantum dots;
forming a magnetic electrode, the magnetic electrode being configured to form a magnetic field gradient at the interface and to receive microwave signals for manipulating the quantum dots.

20. The fabrication method of claim 19, further comprising:
forming a first channel electrode and a second channel electrode both located on the dielectric layer, wherein a one-dimensional channel is formed between the first channel electrode and the second channel electrode, and wherein the confining electrode, the first electrode and the second electrode are all located in the one-dimensional channel.

21. A signal reading method for a semiconductor quantum dot device, **characterized in that**, the semiconductor quantum dot device is the semiconductor quantum dot device of any one of claims 2, 4 to 5, and 7 to 9, or the semiconductor quantum dot device fabricated according to the method of any one of claims 19 to 20, the signal reading method comprising:
providing a magnetic field and applying it to the semiconductor quantum dot device;
providing a voltage and applying it to the first electrode, the second electrode and the confining electrode;
providing a microwave signal and applying it to the magnetic electrode; and
acquiring an electrical signal output by the second electrode.

22. A manipulation method for a semiconductor quantum dot device, **characterized in that**, the semiconductor quantum dot device is the semiconductor quantum dot device of any one of claims 2, 4 to 5, and 7 to 9, or the semiconductor quantum dot device fabricated according to the method of any one of claims 19 to 20, the manipulation method comprising:
forming a magnetic field gradient via the magnetic electrode, to split a valley energy level of the quantum dots and obtain split energy levels; and
applying microwave signals via the magnetic electrode to adjust energy level transitions between the split energy levels, so as to implement manipulation of states of the quantum dots.

23. The manipulation method of claim 22, **characterized in that**,
the split energy levels comprise: a first valley spin energy level, a second valley spin energy level, a third valley spin energy level and a fourth valley spin energy level, wherein the second valley spin energy level and the third valley spin energy level are anti-crossing; and
a frequency of the microwave signals corresponds to transition energy between the second valley spin level and the third valley spin level.

24. A quantum computer, **characterized by** comprising the semiconductor quantum dot device of any one of claims 2, 4 to 5, and 7 to 9, or the semiconductor quantum dot device fabricated according to the method of any one of claims 19 to 20, or the semiconductor quantum dot device manipulated according to the method of any one of claims 22 to 23.
